# EUROPÄISCHE PATENTSCHRIFT

(11) **EP 1 001 325 B1**
(45) Veröffentlichungstag und Bekanntmachung des Hinweises auf die Patenterteilung: **03.07.2002**
(21) Anmeldenummer: 99121131.9
(22) Anmeldetag: 22.10.1999
(51) Int. Cl.: G05D 3/12, H01L 21/00

(54) **Verfahren und Vorrichtung zur Positionierung eines Gegenstandes**
Method and device for positioning an object
Procédé et appareil pour le positionnement d'un objet

(30) Priorität: 11.11.1998 DE 19851941
(43) Veröffentlichungstag der Anmeldung: 17.05.2000
(73) Patentinhaber: Gebr. Schmid GmbH & Co., D-72250 Freudenstadt (DE)
(72) Erfinder: Schmid, Christian, Dipl.-Wirtsch.-Ing., 72280 Dornstetten (DE)
(74) Vertreter: Patentanwälte Ruff, Wilhelm, Beier, Dauster & Partner

(56) Entgegenhaltungen:
- EP-A- 0 311 077
- EP-A- 0 482 553
- US-A- 4 827 140

## Beschreibung

### ANWENDUNGSGEBIET UND STAND DER TECHNIK

Die Erfindung betrifft ein Verfahren zur Positionierung eines Gegenstandes in eine Zielposition nach dem Oberbegriff des Anspruchs 1 sowie eine entsprechende Vorrichtung nach dem Oberbegriff des Anspruchs 12.

Derartige Verfahren und Vorrichtungen werden beispielsweise angewandt, um auf einer Transport- oder Rollenbahn laufende Gegenstände mittig zu zentrieren. Bei einem bekannten Verfahren werden die Gegenstände in Laufrichtung gestoppt, mittels eines Schiebers o. dgl. gegen einen definierten Rand bzw. Anschlag an der Bahn geschoben und aus dem Positionssignal des Schiebers sowie dem Anschlagsignal die Breite des Gegenstandes bestimmt. Davon ausgehend kann der Gegenstand mit Positionierungsmitteln in die Mitte gebracht und weiter transportiert werden. Derartige Positionierungsverfahren werden angewendet für Gegenstände, die in ihre Ausdehnungen variieren, so daß das Erfassen einer seitlichen Begrenzung allein nicht zur Bestimmung ihrer derzeitigen Position ausreicht.

Ein solches Verfahren weist den Nachteil auf, daß zum einen eine mechanische Belastung des Gegenstandes auftritt, die beispielsweise bei sehr dünnen Leiterplatten zu Beschädigungen führen kann. Des weiteren muß der Gegenstand zum Anschlag an den Rand, also zu seiner Erfassung, gestoppt werden und zweimal verfahren werden.

Die US 4,827,140 beschreibt ein Verfahren zur Positionierung eines Werkstücks. Dazu werden zwei an einer gemeinsamen Achse befestigte Sensoren gleichzeitig und gleichgerichtet in Schwenkbewegungen über einen Bereich verfahren. Zur Bestimmung der Position des Werkstücks werden beide Sensoren gemeinsam jeweils über den vollen Bereich geführt, in dem sich das Werkstück befinden kann.

### AUFGABE UND LÖSUNG

Es ist Aufgabe der Erfindung, ein Verfahren und eine entsprechende Vorrichtung zur Positionierung eines Gegenstandes zu entwickeln, die die Nachteile des Standes der Technik vermeiden, insbesondere ein schnelles, genaues und möglichst beschädigungsfreies Positionieren des Gegenstandes ermöglichen sowie vielseitig anwendbar sind.

Gelöst wird diese Aufgabe durch ein Verfahren mit den Merkmalen des Anspruchs 1 sowie eine Vorrichtung mit den Merkmalen des Anspruchs 12. Der Gegenstand wird in Abhängigkeit von dem Erfassen der charakteristischen Punkte positioniert. Insbesondere soll es durch das erfindungsgemäße Verfahren möglich sein, den Gegenstand bereits in die Zielrichtung zu bewegen noch bevor seine genaue Ausgangsposition und/oder Ausdehnung bekannt ist. Ebenso kann seine Position erfaßt werden, wenn er sich noch auf der Transportbahn bewegt.

Die Sensoren werden gegenläufig aus einer Ausgangsposition heraus bewegt, insbesondere gleichzeitig und/oder mit gleicher Geschwindigkeit. Durch das Vorsehen zweier Sensoren, insbesondere mit gewissem Abstand zueinander, kann der Bereich, in dem der Gegenstand zu vermuten ist, schneller abgetastet werden, wenn sich die Sensoren jeweils den abzutastenden Bereich aufteilen. Vorzugsweise ist die Ausgangsposition der Sensoren so gewählt, daß der Gegenstand zwangsläufig dazwischen liegen muß. Alternativ ist es möglich, die Sensoren mit Abstand zueinander anzuordnen und in gleicher Richtung zu bewegen, wobei ihre Ausgangsposition beispielsweise an einer Seite und in der Mitte des abzutastenden Bereichs liegen kann.

Vorteilhaft weisen die Sensoren in der Ausgangsposition eine vorgegebene Zuordnung zu der Zielposition für den Gegenstand auf, wobei sie vorzugsweise symmetrisch dazu angeordnet sind. Dies ist vor allem für ein Verfahren mit gegenläufigen Sensoren von Vorteil, die so bewegt werden, daß sie jederzeit symmetrisch dazu sind.

Die Verwendung einer Vielzahl von Sensoren ist möglich. Bevorzugt werden Sensoren, die den Gegenstand bzw. dessen charakteristischen Punkte berührungslos erfassen, beispielsweise optische Sensoren. Andere Ausführungsvarianten können Sensoren auf induktiver oder kapazitiver Basis vorsehen. Ebenso sind Sensoren mit mechanischer Erfassung möglich, beispielsweise Mikroschalter mit verlängerten, eventuell elastischen, Schaltarmen. Optische Sensoren können einen gewissen Abstand, beispielsweise einige Zentimeter, zu dem Gegenstand aufweisen. Als charakteristische Punkte bzw. Abschnitte des Gegenstandes können seine Außenabmessungen erfaßt werden, jede von einem eigenen Sensor. Nach dem Positionieren befindet sich vorzugsweise seine Mitte an der Zielposition. Es erfolgt also quasi eine Zentrierung. Dabei handelt es sich vorteilhaft um Gegenstände mit einfachen geometrischen Formen, insbesondere rechteckige Gegenstände.

Die Sensoren können mit einer Verfahreinrichtung bewegt werden, wobei bevorzugt jeweils mindestens ein Sensor an einer Verfahreinrichtung angebracht ist. Die Sensoren sollten sich im wesentlichen entlang einer Bahn bewegen ohne sich dabei gegenseitig zu stören. Eine Ausführungsmöglichkeit einer Verfahreinrichtung ist ein als Schleife geführtes Band mit einem Drehantrieb, beispielsweise ein Zahnriemen. Verfahreinrichtungen dieser Art sind beispielsweise bei Plottern anzutreffen. Die Sensoren werden derart daran angebracht werden, daß ihre Funktion durch die Verfahreinrichtung nicht beeinträchtigt wird.

Besonders bevorzugt sind wenigstens zwei, insbesondere genau zwei Sensoren an einer gemeinsamen Verfahreinrichtung angeordnet. Vorzugsweise ist diese ein als Schleife geführtes Band mit einem Sensor an jeder Bahn. Dabei weisen die Sensoren und/oder vorteilhaft die Laufebene der Schleife im wesentlichen auf den Gegenstand zu.

Die Position wenigstens eines Sensors kann erfaßt und als zur Positionierung des Gegenstandes verwendetes Positionssignal aufgenommen werden. Auf diese Weise ist eine Bestimmung der Position des Gegenstandes auf den Sensor möglich, von der ausgehend der Gegenstand zielgenau positioniert wird. Die Position des wenigstens einen Sensors kann bevorzugt an einer Verfahreinrichtung für den Sensor aufgenommen werden, beispielsweise an deren Antrieb. Eine Vereinfachung des Verfahrens läßt sich dadurch erreichen, daß im wesentlichen nur relative Positionsänderungen des Sensors erfaßt werden, wobei in diesem Fall die Sensoren bevorzugt eine vorgegebene Zuordnung zu der Zielposition aufweisen. Auf diese Weise ist keine genaue Kalibrierung der Sensoren nötig. Die Erkennungssignale der Sensoren sind vorteilhaft zusammen mit den Positionssignalen verfügbar und auswertbar.

Im folgenden beziehen sich die Bezeichnungen erster Sensor, zweiter Sensor auf die Reihenfolge, in der die Sensoren den Gegenstand erfassen. Bei einer Ausgestaltungsmöglichkeit der Erfindung kann die Wegdifferenz zwischen einerseits der Position eines der Sensoren, bevorzugt des zweiten Sensors, in dem Moment, in dem der erste Sensor seinen charakteristischen Punkt an dem Gegenstand erreicht, und andererseits der Position, in der der zweite Sensor seinen charakteristischen Punkt erreicht, aufgenommen werden. Daraus ist bei einer vorgegebenen Zuordnung der Sensoren zu der Zielposition die derzeitige Lage des Gegenstandes ermittelbar. Somit kann der Gegenstand anschließend durch Positionierungsmittel erfaßt werden und, bei symmetrischer Anordnung der Sensoren zur Zielposition, um die halbe Wegdifferenz in der Bewegungsrichtung des ersten Sensors bewegt werden. Daraufhin befindet er sich in der Zielposition und wird von den Positionierungsmitteln freigegeben. Der Vorteil einer bestimmten Zuordnung der Sensoren zu der Zielposition liegt demzufolge darin, daß die Erfassung relativer Positionsänderungen der Sensoren ausreicht.

Es ist möglich, wenigstens einen Sensor zumindest teilweise synchron mit Positionierungsmitteln für den Gegenstand zu bewegen. Als vorteilhaft wird eine Kombination der Verfahreinrichtung für wenigstens einen Sensor mit den Positionierungsmitteln angesehen, wobei die Verfahreinrichtung vorzugsweise Teil der Positionierungsmittel ist und/oder diese im wesentlichen bildet. Ein oben beschriebenes Band einer Verfahreinrichtung kann zum Positionieren des Gegenstandes, z.B durch Anheben verwendet werden.

Eine besonders einfache Ausbildung des erfindungsgemäßen Verfahrens sieht vor, daß zwei Sensoren aus einer Ausgangsposition, in der sie eine vorgegebene Zuordnung zu charakteristischen Punkten des Gegenstandes und/oder dessen Zielposition aufweisen, entlang einer Bahn so lange synchron gegenläufig relativ zu dem Gegenstand verfahren werden, bis ein erster Sensor seinen charakteristischen Punkt an dem Gegenstand erreicht hat. Darauf hin kann der Gegenstand durch die Positionierungsmittel erfaßt und mit seinem zweiten charakteristischen Punkt in Richtung auf den zweiten Sensor zubewegt werden, also weiterhin in der ursprünglichen Bewegungsrichtung des ersten Sensors. Dabei werden die Sensoren gleichzeitig mit den Positionierungsmitteln bewegt, wobei sie insbesondere mechanisch mit diesen gekoppelt bzw. daran befestigt sind. Der zweite Sensor bewegt sich dabei synchron gegenläufig zu dem Gegenstand. Nachdem der zweite Sensor den zweiten charakteristischen Punkt des Gegenstandes erreicht hat, befindet sich dieser in der Zielposition und wird freigegeben. Besonders einfach ist dies bei symmetrisch zu der Zielposition angeordneten Sensoren und einem Gegenstand, dessen Mitte in die Zielposition gebracht werden soll. Bei einem solchen Verfahren ist keine Positionserfassung der Sensoren erforderlich.

Der Gegenstand kann solange, beispielsweise entlang einer Transporteinrichtung, bewegt werden, bis der erste Sensor seinen ersten charakteristischen Punkt erfaßt hat. Auf diese Weise ist die Unterbrechungszeit zur Positionierung des Gegenstandes möglichst kurz.

Des weiteren beinhaltet die Erfindung eine Vorrichtung zur Positionierung eines Gegenstandes in eine Zielposition, wobei der Gegenstand insbesondere ein Substrat in der Elektronikindustrie ist, wie beispielsweise eine Leiterplatte.

Im Gegensatz zu den oben beschriebenen bekannten Vorrichtungen mit mechanischen Anschlägen zur Ermittlung der Position bzw. Positionierung des Gegenstandes weist die erfindungsgemäße Vorrichtung wenigstens zwei Sensoren auf, die zur Erfassung des Gegenstandes ausgebildet sind und im wesentlichen entlang der Positionierungsrichtung des Gegenstandes bewegbar sind. Darüber hinaus ist eine Steuerung vorhanden, die mit den Sensoren verbunden ist, sowie Positionierungsmittel zur Positionierung des Gegenstandes in die Zielposition in Abhängigkeit von der Steuerung. Durch die Verwendung von Sensoren, insbesondere berührungsfreien, wie beispielsweise optischen Sensoren, sind mechanische Einwirkungen auf die Seiten der Gegenstände nicht nötig.

Die Sensoren sind an wenigstens einer Verfahreinrichtung angebracht, die sie vorzugsweise synchron in gegenläufiger Richtung bewegt. Vorteilhaft sind sie an einer gemeinsamen Verfahreinrichtung angebracht. Eine Ausführungsmöglichkeit einer Verfahreinrichtung ist ein als Schleife geführtes Band mit einem Antrieb, das insbesondere an jeder Bahn der Schleife einen Sensor aufweist. Die Sensoren und/oder die Laufebene der Schleife weisen vorteilhaft im wesentlichen, insbesondere genau, auf den Gegenstand zu. Dabei sind die Sensoren derart angeordnet, daß sie weder durch sich selbst noch durch die Verfahreinrichtung in ihrer Funktion negativ beeinträchtigt werden. Weiters kann wenigstens eine Positionserfassungseinrichtung für die Position wenigstens eines Sensors vorgesehen sein, welche mit der Steuerung für die Positionierungsmittel und die Sensoren verbunden ist. Bevorzugt ist die Positionserfassungseinrichtung mit einem Antrieb und/oder der Verfahreinrichtung für die Sensoren verbunden, beispielsweise als Inkrementalgeber.

Bevorzugt weisen die Sensoren in ihrer Ausgangsposition eine vorgegebene Zuordnung zu der Zielposition für den Gegenstand auf, wobei sie insbesondere symmetrisch zu der Zielposition angeordnet sind. Eine mögliche Ausgangsposition sieht vor, daß bei jeder möglichen Lage des Gegenstandes die Sensoren mit Abstand dazu den Gegenstand zwischen sich einschließend angeordnet sind.

Die Vorrichtung kann vereinfacht werden, wenn wenigstens eine Verfahreinrichtung für die Sensoren Bestandteil der Positionierungsmittel für den Gegenstand ist. Dabei kann die Verfahreinrichtung in Wirkverbindung mit dem Gegenstand gebracht werden. Vorzugsweise bildet die Verfahreinrichtung im wesentlichen die Positionierungsmittel, beispielsweise als oben beschriebenes in einer Schleife geführtes Band, wobei vorzugsweise mehrere Bänder die Positionierungsmittel bilden, von denen wenigstens eines Sensoren trägt.

Bei einer Ausgestaltungsmöglichkeit der Erfindung befindet sich der Gegenstand auf einer Unterlage, vorzugsweise eine Rollenbahn o. dgl. zum Transport des Gegenstandes. Unterhalb des Gegenstandes sind Verfahreinrichtung und/oder Positionierungsmittel angeordnet und können durch Unterbrechungen in der Unterlage nach oben bewegt werden. Die Positionierungsrichtung verläuft im wesentlichen quer zur Transportrichtung des Gegenstandes. Die Breite der Verfahreinrichtung ist vorzugsweise etwas geringer als die einer Rollenbahn, so daß die Verfahreinrichtung problemlos durch die einzelnen Transportrollen hindurchgreifen kann. Es ist dafür zu sorgen, daß sich die Gegenstände jeweils nur innerhalb des von den Sensoren abgetasteten Bereichs befinden können.

Diese und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können, für die hier Schutz beansprucht wird. Die Unterteilung der Anmeldung in einzelne Abschnitte sowie Zwischen-Überschriften beschränkt die unter diesen gemachten Aussagen nicht in ihrer Allgemeingültigkeit.

### KURZBESCHREIBUNG DER ZEICHNUNGEN

Zwei Ausführungsbeispiele der Erfindung sind in den Zeichnungen dargestellt und werden im folgenden näher erläutert. In den Zeichnungen zeigen:
- Fig. 1: ein Ausführungsbeispiel der Erfindung mit einer als Positionierungsmittel ausgebildeten Verfahreinrichtung für zwei Sensoren, wobei eine Positionserfassungseinrichtung für die Sensoren vorgesehen ist und
- Fig. 2: eine Abwandlung der Vorrichtung gemäß Fig. 1, bei der die Zentrierung des Gegenstandes durch die vorgegebene Anordnung der Sensoren ohne Positionserfassung möglich ist.

### DETAILLIERTE BESCHREIBUNG DER AUSFÜHRUNGSBEISPIELE

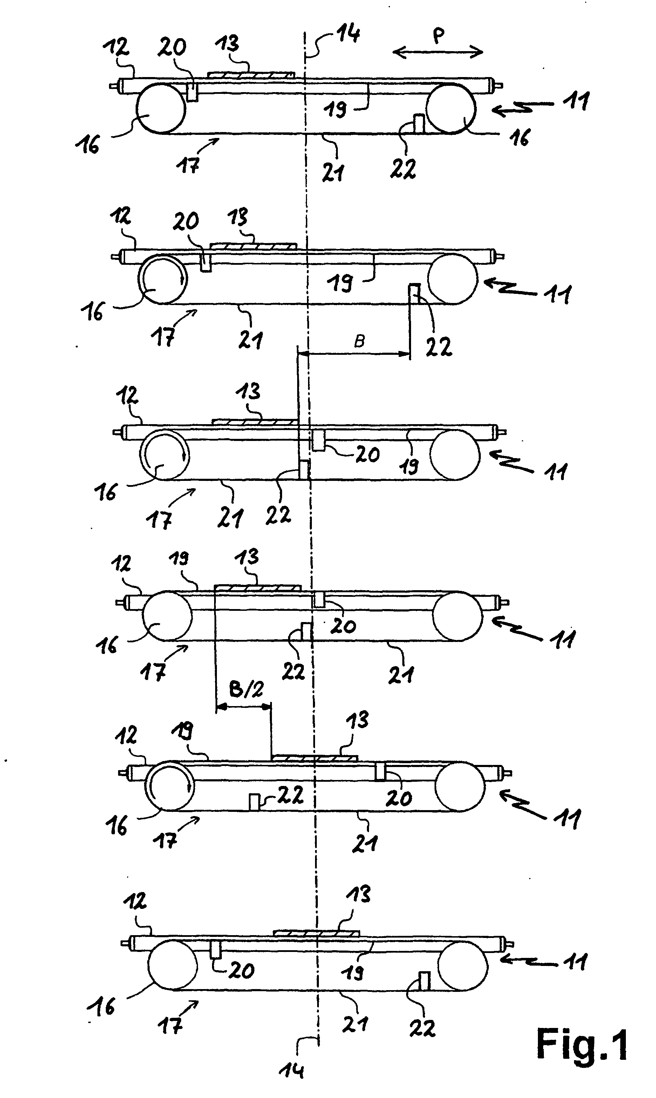

Die erste Darstellung in Fig. 1 zeigt eine Ausführung einer erfindungsgemäßen Positionierungsvorrichtung 11, die innerhalb von Transportrollen 12 angeordnet ist. Die Transportrollen 12 bilden eine senkrecht zur Zeichenebene verlaufende Rollenbahn zum Transport eines darauf liegenden Gegenstandes, beispielsweise einer Leiterplatte 13. Strichpunktiert ist eine Zielposition 14 für die Leiterplatte 13 vorgegeben, die im dargestellten Fall mittig zu den Transportrollen 12 liegt. Möglich sind jedoch auch seitlich dazu versetzte Positionen.

Die Positionierungsvorrichtung 11 besteht aus zwei Rollen 16, um die in einer Schleife ein Band 17 geführt ist. Gemäß einer Möglichkeit können das Band 17 als Zahnriemen o. dgl. und die Rollen 16 entsprechend ausgeführt sein, um einen Schlupf beim Antrieb zu vermeiden. Ein Antrieb für die Positionierungsvorrichtung 11, vorzugsweise ein Elektro- oder Servomotor, kann in wenigstens einer der beiden Rollen 16 angeordnet bzw. damit gekoppelt sein. An einer der Rollen 16 bzw. einem Antrieb für sie kann eine nicht dargestellte Positionserfassungseinrichtung vorgesehen sein, beispielsweise als Inkrementalgeber. An dem Band 17 sind zwei Sensoren angebracht, an seiner oberen Bahn 19 ein oberer Sensor 20 und an seiner unteren Bahn 21 ein unterer Sensor 22. Die beiden Sensoren 20 und 22 sind ebenso wie die Rollen 16 symmetrisch zu der Zielposition 14 angeordnet, wobei diese Symmetrie in jeder möglichen Position während des Verfahrens des Bandes 17 erhalten bleibt. Die Arbeits- bzw. Erfassungsrichtung der Sensoren 20 und 22 verläuft dabei in Fig. 1 nach oben, im wesentlichen senkrecht zu den Transportrollen 12.

In der zweiten Darstellung in Fig. 1 wurden, ausgehend von der ersten Darstellung, durch Drehen der Rollen 16 im Uhrzeigersinn die Sensoren 20 und 22 jeweils in Richtung auf die Zielposition 14 zu verfahren. Dargestellt ist der Zustand, in dem der obere Sensor 20 als erster Sensor den linken Rand der Leiterplatte 13 erreicht hat. Zur Vereinfachung ist in den Zeichnungen eine Erfassung der Leiterplatte 13 durch die Sensoren 20, 22 dergestalt dargestellt, sobald der Rand eines der Sensoren mit dem Rand der Leiterplatte übereinstimmt bzw. fluchtet. In der Realität weisen die Sensoren bevorzugt eine punkt- bzw. strichförmige Erfassung auf, wobei sie entweder einen bestimmten Übergang von bedeckt zu unbedeckt bzw. umgekehrt oder lediglich eine Änderung der Überdeckung erfassen können. In diesem Zustand wird von der Positionserfassungseinrichtung die Position des unteren Sensors 22 entweder ermittelt (absolut) oder als neuer Nullpunkt verwendet (relativ).

In der dritten Darstellung ist der untere Sensor 22 bis unter den rechten Rand der Leiterplatte 13 verfahren, wobei in diesem Zustand erneut seine Position aufgenommen wird. Die Wegdifferenz zwischen der Position des unteren Sensors 22 in der zweiten und seiner Position in der dritten Darstellung wird (relativ) als Wegdifferenz B erfaßt. Das Band 17 hat in dem Moment, in dem der untere Sensor 22 den rechten Rand der Leiterplatte 13 erreicht hat, gestoppt.

In der vierten Darstellung ist zu sehen, wie die Positinierungsvorrichtung 11 nach oben angehoben wurde und die Leiterplatte 13 von der Transportrolle 12 abhebt, so daß diese auf der oberen Bahn 19 des Bandes 17 zu liegen kommt. In diesem Zustand dient das Band als Positionierungsvorrichtung 11.

In der fünften Darstellung wurde die Leiterplatte 13 um die halbe Wegdifferenz B/2 in der ursprünglichen Bewegungsrichtung des Bandes 17 bzw. des oberen Sensors 20, also in Positionierungsrichtung P, verfahren, so daß sie mittig zu der Zielposition 14 ist. Die Wegdifferenz B/2 wird von der Steuerung der Positionierungsvorrichtung 11 aus der Wegdifferenz B berechnet. Das Zurücklegen der halben Wegdifferenz B/2 durch das Band 17 wird beispielsweise durch einen Inkrementalgeber an dem Antrieb bzw. den Rollen 16 des Bandes ermittelt. Daß die Sensoren 20 und 22 beim Verfahren der Leiterplatte 13 mitbewegt werden, stört den Positionierungsvorgang nicht. Nachdem die Leiterplatte 13 in ihrer Zielposition 14 ist, wird das Band 17 wieder unter die Transportrollen 12 abgesenkt, wobei die Leiterplatte abgelegt wird. Anschließend werden die Sensoren 20 und 22 wieder in ihre Ausgangsposition gemäß der ersten Darstellung verfahren, wie in der sechsten Darstellung zu sehen ist. Alternativ ist es möglich, ausgehend von der fünften Darstellung, den oberen Sensor 20 nach ganz rechts und den unteren Sensor 22 nach ganz links bis kurz vor die Rollen 16 zu verfahren, also umgekehrt wie in der ersten Darstellung. Dies spart etwas Weg und Zeit beim Querverfahren der Sensoren.

Als Alternative zu der in Fig. 1 dargestellten Positionierung ist es möglich, je nach Ausgangsposition der Leiterplatte 13 unterschiedliche Positionserfassungen vorzunehmen. Wie in Fig. 1 zu sehen ist, hat der obere Sensor 20 beide Ränder der Leiterplatte 13 erfaßt, bevor der untere Sensor 22 den rechten Rand erreicht hat. Um Zeit zu sparen, kann durch Positionsabfragen des oberen Sensors 20 die Breite der Leiterplatte 13 ermittelt werden. Ist eine absolute Positionserfassung der Sensoren 20 und 22 vorgesehen, kann mit der Position der Randbegrenzungen der Leiterplatte 13 sowohl deren Breite als auch deren genaue Lage auf den Transportrollen 12 bzw. relativ zu der Zielposition 14 ermittelt werden. Davon ausgehend kann die Positionierungsvorrichtung 11 die Leiterplatte 13 in der ursprünglichen Bewegungsrichtung des oberen Sensors 20. in die Zielposition 14 bewegen, nämlich um den Abstand der errechneten Mitte der Leiterplatte zu der Zielposition. Dieses Verfahren ist dann von Vorteil weil schneller, wenn die Leiterplatte 13 in ihrer Ausgangsposition so liegt, daß einer der Sensoren, entweder der obere Sensor 20 oder der untere Sensor 22, beide Randbegrenzungen der Leiterplatte erfaßt hat, bevor der jeweils andere Sensor die Leiterplatte erreicht hat. Bei einer eher in der Mitte liegenden Leiterplatte ist das in Fig. 1 dargestellte Verfahren schneller. Eine besonders vorteilhafte, wenn auch relativ aufwendige, Vorrichtung erfaßt gleichzeitig die absolute Position beider Sensoren und entscheidet in Abhängigkeit davon, ob zuerst ein Sensor die Leiterplatte vollständig passiert hat oder der zweite Sensor vorher die Leiterplatte erreicht hat, wie die Ausdehnung der Leiterplatte bzw. ihre Position zu ermitteln ist und berechnet daraus den notwendigen Verfahrweg.

Beim Aktivieren der Positionierungsvorrichtung 11 ist es nicht unbedingt notwendig, daß die Sensoren genau in der Position verharren, in der zum zweiten Mal die Randbegrenzung der Leiterplatte 13 erfaßt worden ist. Das Band 17 muß nur in dem Moment stillstehen, in dem es die Leiterplatte 13 anhebt. Auf diese Weise ist es möglich, das Band 17 beim Verfahren der Sensoren sehr schnell zu bewegen und nicht unbedingt punktgenau abzubremsen, sondern erst während des Anhebens.

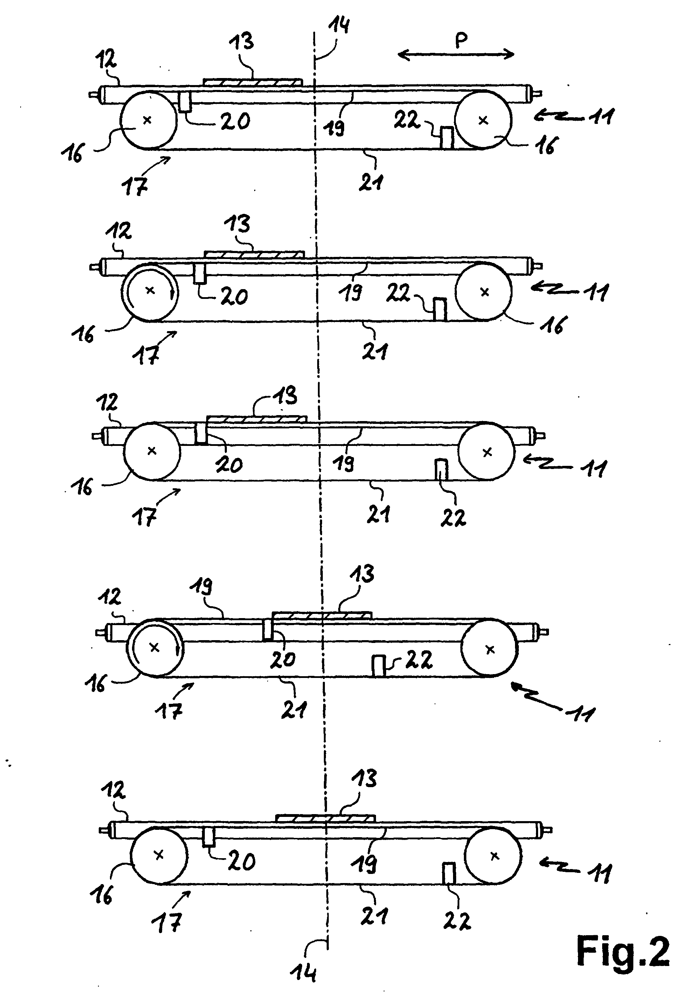

Ein alternatives Verfahren zur Positionierung der Leiterplatte 13 ist in Fig. 2 dargestellt, wobei die Vorrichtung im wesentlichen der aus Fig. 1 entspricht. Allerdings weist sie den Vorteil auf, daß keine Positionserfassungseinrichtung für die Sensoren 20, 22 oder das Band 17 notwendig ist. Die erste Darstellung entspricht der ersten Darstellung aus Fig. 1 und zeigt eine nach links von der Zielposition 14 versetzte Leiterplatte 13 auf den Transportrollen 12.

Die zweite Darstellung zeigt, daß durch Drehen der Rollen 16 im Uhrzeigersinn die Sensoren 20 und 22 aus der Ausgangsposition heraus auf die Zielposition 14 zubewegt werden. Dabei hat der obere Sensor 20 den linken Rand der Leiterplatte 13 erreicht. Das Band 17 wird möglichst genau in diesem Moment gestoppt und die Positionierungsvorrichtung 11 angehoben, so daß die obere Bahn 19 des Bandes die Leiterplatte 13 von den Transportrollen 12 abhebt, siehe dritte Darstellung.

Anschließend wird das Band 17 in Positionierungsrichtung P in der ursprünglichen Laufrichtung weiterbewegt, wobei die Leiterplatte 13 in Richtung auf den unteren Sensor 22 zu bewegt wird. Sobald der untere Sensor 22 den rechten Rand der Leiterplatte 13 erreicht hat, wird das Band 17 möglichst schnell gestoppt, siehe vierte Darstellung. Aufgrund der Anordnung der Sensoren 20 und 22 symmetrisch zur Zielposition 14 befindet sich die Leiterplatte 13 nun genau mittig in der Zielposition 14. Demzufolge kann die Positionierungsvorrichtung 11 abgesenkt werden, die Leiterplatte 13 auf den Transportrollen 12 abgelegt werden und die Sensoren 20 und 22 wieder in ihre Ausgangsposition gebracht werden, siehe fünfte Darstellung.

Dies ist ein gegenüber dem vorstehend beschriebenen Verfahren sehr einfaches Verfahren, da es zum einen ohne Positionserfassungseinrichtung und zum anderen mit minimalen Verfahrwegen für die Sensoren auskommt und damit sehr zeitsparend ist. Voraussetzungen sind lediglich eine Zuordnung der Sensoren zu der Zielposition 14 sowie der zu erwartenden Art der Leiterplatte 13 und des Verhältnisses, in dem die Leiterplatte 13 zu der Zielposition zu liegen kommen soll. Bevorzugt ist dies die in Fig. 2 dargestellte symmetrische bzw. zentrische Möglichkeit. Weiters ist es möglich, nicht zentrisch zu positionieren. Dabei kann die Leiterplatte 13 nicht nach Erreichen eines Randes durch einen beliebigen Sensor verfahren werden, sondern es muß beispielsweise immer erst der obere Sensor 20 den linken Rand der Leiterplatte erreichen, wodurch bestimmte vorgebbare Positionierungen möglich sind. Hier ist wieder eine genaue Vorgabe der Position der Sensoren zu der Zielposition notwendig.

Eine weitere Voraussetzung für das Verfahren gemäß Fig. 2 sollte das möglichst sofortige Abbremsen des Bandes 17 sein, nachdem einer der Sensoren den Rand der Leiterplatte 13 erfaßt hat. Ist dies nicht zufriedenstellend möglich, kann entweder der eventuell experimentell ermittelte Bremsweg jeweils rechnerisch ausgeglichen werden oder ein Sensor nach Passieren des Randes mit hoher Geschwindigkeit mit langsamer Geschwindigkeit in Gegenrichtung zur exakten Randerfassung zurückgefahren werden. Ebenfalls ist es möglich, die Bremswege durch die jeweils gegenläufige Bewegung der Sensoren zueinander gegeneinander auszugleichen, beispielsweise indem das Band 17 beim Positionieren der Leiterplatte 13 genau gleich bewegt und abgebremst wird wie beim Verfahren der Sensoren zur Erfassung des Randes der Leiterplatte 13 durch einen ersten Sensor. Auf diese Weise heben sich die gleich großen Bremswege auf.

Es ist selbstverständlich, daß anstelle zweier Sensoren 20 und 22 an einem Band 17 pro Sensor ein eigenes Band vorgesehen sein kann, wobei die Bänder bevorzugt gleichzeitig und derart bewegt werden, daß die Sensoren entsprechend den Fig. 1 und 2 verfahren werden. Anstelle eines Bandes sind Linearantriebe o. dgl. möglich. Ebenso ist es möglich, als Ausgangsposition der Sensoren in jeweils der ersten Darstellung der Figuren 1 und 2 die Zielposition 14 zu bestimmen.

Durch die Erfindung wird ein Abtasten des Bereichs ermöglicht, indem sich die Leiterplatte 13 befinden kann, wobei durch das Vorsehen zweier Sensoren dieser Vorgang erheblich verkürzt wird. Bei einer Ausführung gemäß Fig. 2 wird bereits mit dem Positionieren des Gegenstandes begonnen noch bevor eindeutig seine Lage bzw. Größe ermittelt ist. Hier befindet sich der Gegenstand durch die besondere Zuordnung der Sensoren zu der Zielposition beim endgültigen Erfassen seiner Größe bereits in der Zielposition.

Es ist möglich, beim Vorgang der Positionserfassung des Gegenstandes, zumindest bis zur Erfassung eines Randes, den Gegenstand beispielsweise auf einer Transportbahn zu bewegen und erst nach diesem Erfassen abzustoppen.

## Patentansprüche

1. Verfahren zur Positionierung eines Gegenstandes (13), der insbesondere ein Substrat in der Elektronikindustrie ist, in eine Zielposition (14), bei dem wenigstens zwei Sensoren (20, 22) zur Erfassung des Gegenstandes entlang der Positionierungsrichtung (P) bewegt werden und sie nacheinander jeweils einen charakteristischen Punkt des Gegenstandes erfassen, wobei der Gegenstand in Abhängigkeit von dem Erfassen der charakteristischen Punkte positioniert wird, **dadurch gekennzeichnet, daß** die Sensoren (20, 22) gegenläufig aus einer Ausgangsposition heraus bewegt werden.

2. Verfahren nach Anspruch 1, **dadurch gekennzeichnet, daß** die Sensoren (20, 22) gleichzeitig und/oder mit gleicher Geschwindigkeit bewegt werden, wobei sie vorzugsweise in der Ausgangsposition den Gegenstand (13) zwischen sich haben.

3. Verfahren nach Anspruch 1 oder 2, **dadurch gekennzeichnet, daß** die Sensoren (20, 22) in einer Ausgangsposition eine vorgegebene Zuordnung zu der Zielposition (14) aufweisen, vorzugsweise symmetrisch zu der Zielposition angeordnet sind.

4. Verfahren nach einem der vorhergehenden Ansprüche, **dadurch gekennzeichnet, daß** die Sensoren (20, 22) die charakteristischen Punkte des Gegenstandes (13) berührungslos erfassen, vorzugsweise optisch.

5. Verfahren nach einem der Ansprüche, **dadurch gekennzeichnet, daß** als die charakteristischen Punkte bzw. Abschnitte des Gegenstandes (13) seine Außenabmessungen erfaßt werden, wobei sich vorzugsweise nach dem Positionieren des Gegenstandes seine Mitte an der Zielposition (14) befindet.

6. Verfahren nach einem der vorhergehenden Ansprüche, **dadurch gekennzeichnet, daß** jeweils mindestens ein Sensor (20, 22) mit einer Verfahreinrichtung bewegt wird, die vorzugsweise ein als Schleife geführtes Band (17) mit einem Antrieb ist.

7. Verfahren nach Anspruch 6, **dadurch gekennzeichnet, daß** wenigstens zwei Sensoren (20, 22) mit einer gemeinsamen Verfahreinrichtung bewegt werden, vorzugsweise an jeder Bahn (19, 21) eines als Schleife geführten Bandes (17) ein Sensor (20, 22) mit Richtung auf den Gegenstand (13) zu angeordnet ist, wobei insbesondere die Laufebene der Schleife im wesentlichen auf den Gegenstand zu weist.

8. Verfahren nach einem der vorhergehenden Ansprüche, **dadurch gekennzeichnet, daß** die Position wenigstens eines Sensors (20, 22) erfaßt und als zur Positionierung des Gegenstandes (13) verwendetes Positionssignal aufgenommen wird, insbesondere mittels einer Verfahreinrichtung (17) für den Sensor aufgenommen wird, wobei vorzugsweise relative Positionsänderungen des Sensors erfaßt werden.

9. Verfahren nach Anspruch 8, **dadurch gekennzeichnet, daß** die Wegdifferenz (B) zwischen der Position des zweiten Sensors (22) in dem Moment, in dem der erste Sensor (20) seinen charakteristischen Punkt erreicht, und der Position, in der der zweite Sensor seinen charakteristischen Punkt erreicht, aufgenommen wird, der Gegenstand (13) durch Positionierungsmittel (11) erfaßt wird und um die halbe Wegdifferenz (B/2) in der Bewegungsrichtung des ersten Sensors bewegt wird, woraufhin er in der Zielposition (14) ist und von den Positionierungsmitteln freigegeben wird.

10. Verfahren nach einem der vorhergehenden Ansprüche, **dadurch gekennzeichnet, daß** wenigstens ein Sensor (20, 22) zumindest teilweise synchron mit Positionierungsmitteln (11) für den Gegenstand (13) bewegt wird, wobei vorzugsweise eine Verfahreinrichtung (17) für den Sensor Teil der Positionierungsmittel ist, insbesondere die Positionierungsmittel bildet.

11. Verfahren nach einem der vorhergehenden Ansprüche, **dadurch gekennzeichnet, daß** zwei Sensoren (20, 22) aus einer Ausgangsposition heraus, in der sie eine vorgegebene Zuordnung zu charakteristischen Punkten des Gegenstandes (13) und/oder der Zielposition (14) aufweisen, entlang einer Bahn solange synchron gegenläufig relativ zu dem Gegenstand verfahren werden, bis ein erster Sensor (20) seinen charakteristischen Punkt an dem Gegenstand erreicht hat, daraufhin der Gegenstand durch die Positionierungsmittel (11) erfaßt wird und mit seinem zweiten charakteristischen Punkt in Richtung auf den zweiten Sensor (22) zubewegt wird, wobei die Sensoren gleichzeitig mit den Positionierungsmitteln bewegt werden, insbesondere der zweite Sensor gegenläufig zu dem Gegenstand, und der Gegenstand, nachdem der zweite Sensor den zweiten charakteristischen Punkt erreicht hat, in der Zielposition ist und freigegeben wird.

12. Vorrichtung zur Positionierung eines Gegenstandes (13) in eine Zielposition (14), wobei insbesondere der Gegenstand ein Substrat in der Elektronikindustrie ist, wobei sie wenigstens zwei Sensoren (20, 22) aufweist, die zur Erfassung des Gegenstandes ausgebildet sind und im wesentlichen entlang der Positionierungsrichtung (P) des Gegenstandes bewegbar sind, mit einer Steuerung, die mit wenigstens einem Sensor verbunden ist, und mit Positionierungsmitteln (11) zur Positionierung des Gegenstandes in die Zielposition in Abhängigkeit von der Steuerung, **dadurch gekennzeichnet, daß** die Sensoren (20, 22) an wenigstens einer Verfahreinrichtung (17) angebracht sind, die die Sensoren in gegenläufiger Richtung bewegt.

13. Vorrichtung nach Anspruch 12, **dadurch gekennzeichnet, daß** die Sensoren (20, 22) an wenigstens einer gemeinsamen Verfahreinrichtung (17) angebracht sind, die die Sensoren synchron in gegenläufiger Richtung bewegt.

14. Vorrichtung nach Anspruch 13, **dadurch gekennzeichnet, daß** die Verfahreinrichtung ein als Schleife geführtes Band (17) mit einem Antrieb ist, das insbesondere an jeder Bahn (19, 21) einen Sensor (20, 22) mit Richtung auf den Gegenstand (13) zu aufweist, wobei vorzugsweise die Laufebene der Schleife im wesentlichen auf den Gegenstand zu weist.

15. Vorrichtung nach einem Ansprüche 12 bis 14, **dadurch gekennzeichnet, daß** die Sensoren (20, 22) in einer Ausgangsposition eine vorgegebene Zuordnung zu der Zielposition (14) aufweisen, wobei sie vorzugsweise symmetrisch zu der Zielposition angeordnet sind.

16. Vorrichtung nach einem der Ansprüche 12 bis 15, **gekennzeichnet durch** wenigstens eine Positionserfassungseinrichtung für die Position wenigstens eines Sensors (20, 22), die mit der Steuerung für die Positionierungsmittel (11) und die Sensoren verbunden ist, wobei die Positionserfassungseinrichtung vorzugsweise mit einem Antrieb und/oder der Verfahreinrichtung (17) für die Sensoren verbunden ist.

17. Vorrichtung nach Anspruch 13 oder 14, **dadurch gekennzeichnet, daß** wenigstens eine Verfahreinrichtung (17) für die Sensoren (20, 22) Bestandteil der Positionierungsmittel (11) für den Gegenstand (13) ist, insbesondere in Wirkverbindung mit dem Gegenstand bringbar ist, wobei vorzugsweise die Verfahreinrichtung im wesentlichen die Positionierungsmittel bildet.

18. Vorrichtung nach einem der Ansprüche 12 bis 17, **dadurch gekennzeichnet, daß** die Verfahreinrichtung (17) und/oder die Positionierungsmittel (11) unterhalb des Gegenstandes (13), der sich auf einer Unterlage (12) befindet, angeordnet sind und durch Unterbrechungen in der Unterlage nach oben bewegbar sind und in Positionierungsrichtung (P) arbeiten, wobei die Unterlage vorzugsweise eine Rollenbahn o.dgl. zum Transport des Gegenstandes ist, welche insbesondere in eine Richtung quer zur Positionierungsrichtung verläuft.

## Claims

1. Method for positioning an object (13), which is in particular an electronics industry substrate, in a target position (14), in which at least two sensors (20, 22) are moved along the positioning direction (P) for detecting the object and successively detect in each case one characteristic point of the object, the object being positioned as a function of the detection of the characteristic points, **characterized in that** the sensors (20, 22) are moved in opposition out of a starting position.

2. Method according to claim 1, **characterized in that** the sensors (20, 22) are moved simultaneously and/or at the same speed and preferably in the starting position have the object (13) between them.

3. Method according to claim 1 or 2, **characterized in that** the sensors (20, 22) have in a starting position a predetermined association with the target position (14) and are preferably positioned symmetrically to the target position.

4. Method according to one of the preceding claims, **characterized in that** the sensors (20, 22) detect in non-contacting manner and preferably optically the characteristic points of the object (13).

5. Method according to one of the claims, **characterized in that** as characteristic points or portions of the object (13) its external dimensions are detected and preferably, following the positioning of the object, its centre is located at the target position (14).

6. Method according to one of the preceding claims, **characterized in that** in each case at least one sensor (20, 22) is moved with a conveying device, which is preferably a belt (17) guided in loop form and having a drive.

7. Method according to claim 6, **characterized in that** at least two sensors (20, 22) are moved with a common conveying device and preferably on each strand (19, 21) of a belt (17) guided in loop form a sensor (20, 22) is positioned in the direction of the object (13) and in particular the running plane of the loop is essentially directed towards the object.

8. Method according to one of the preceding claims, **characterized in that** the position of at least one sensor (20, 22) is detected and recorded as a position signal used for positioning the object (13) and is in particular recorded by means of a conveying device (17) for the sensor and preferably relative sensor position changes are detected.

9. Method according to claim 8, **characterized in that** the path difference (B) between the position of the second sensor (22) at the instant when the first sensor (20) reaches its characteristic point, and the position in which the second sensor reaches its characteristic point is recorded, the object (13) is detected by positioning means (11) and is moved by half the path difference (B/2) in the movement direction of the first sensor and then is in the target position (14) and is released by the positioning means.

10. Method according to one of the preceding claims, **characterized in that** at least one sensor (20, 22) is moved at least partly in synchronous manner with the positioning means (11) for the object (13) and preferably a conveying device (17) for the sensor is part of the positioning means and in particular forms the positioning means.

11. Method according to one of the preceding claims, **characterized in that** two sensors (20, 22) are moved out of a starting position where they have a predetermined association with characteristic points of the object (13) and/or have the target position (14), along a path in synchronous opposing manner relative to the object until a first sensor (20) has reached its characteristic point on the object, the object is then detected by the positioning means (11) and with its second characteristic point is moved in the direction of the second sensor (22), the sensors being moved simultaneously with the positioning means and in particular the second sensor moves in the opposite direction to the object which, after the second sensor has reached the second characteristic position, is in the target position and is released.

12. Device for positioning an object (13) in a target position (14), the object more particularly being an electronics industry substrate, having at least two sensors (20, 22) constructed for detecting the object and movable essentially along the positioning direction (P) of the object, having a control connected to at least one sensor and having positioning means (11) for positioning the object in the target position as a function of the control, **characterized in that** the sensors (20, 22) are fitted to at least one conveying device (17) moving the sensors in opposite direction.

13. Device according to claim 12, **characterized in that** the sensors (20, 22) are fitted to at least one common conveying device (17) moving the sensors synchronously in opposite directions.

14. Device according to claim 13, **characterized in that** the conveying device is a belt (17) guided in loop form and having a drive, which in particular has on each strand (19, 21) a sensor (20, 22) directed towards the object (13) and preferably the running plane of the loop is essentially directed towards the object.

15. Device according to one of the claims 12 to 14, **characterized in that** in a starting position the sensors (20, 22) have a predetermined association with the target position (14) and are preferably positioned symmetrically to the target position.

16. Device according to one of the claims 12 to 15, **characterized by** at least one position detection device for the position of at least one sensor (20, 22), which is connected to the control for the positioning means (11) and the sensors, the position detection device preferably being connected to a drive and/or the sensor conveying device (17).

17. Device according to claim 13 or 14, **characterized in that** at least one conveying device (17) for the sensors (20, 22) is part of the positioning means (11) for the object (13) and can in particular be brought into operative connection with the object and preferably the conveying device essentially forms the positioning means.

18. Device according to one of the claims 12 to 17, **characterized in that** the conveying device (17) and/or the positioning means (11) are located beneath the object (13), which is positioned on a support (12) and are upwardly movable through interruptions in the support and operating in the positioning direction (P), the support preferably being a roller conveyor or the like for conveying the object, which in particular runs in a direction transverse to the positioning direction.

## Revendications

1. Procédé pour le positionnement d'un objet (13), qui est notamment un substrat d'électronique industrielle, dans une position que l'on se propose d'atteindre ou de but (14), pour lequel au moins deux organes sensitifs (20, 22) sont déplacés pour la détection de l'objet le long de la direction de positionnement (P) et pour lequel ils détectent consécutivement chacun un point distinctif de l'objet, l'objet étant positionné en dépendance du captage des points distinctifs, **caractérisé en ce que** les organes sensitifs (20, 22) sont déplacés en marchant réciproquement en sens inverse à partir d'une position initiale.

2. Procédé d'après la revendication 1, **caractérisé en ce que** les organes sensitifs (20, 22) sont déplacés simultanément et/ou à la même vitesse, en ayant entre eux l'objet (13) de préférence en position initiale.

3. Procédé d'après la revendication 1 ou 2, **caractérisé en ce que** les organes sensitifs (20, 22) présentent dans une position initiale une attribution prédéterminée par rapport à une position de but (14) en étant disposés de préférence symétriquement par rapport à la position de but.

4. Procédé d'après une des revendications précédentes, **caractérisé en ce que** les organes sensitifs (20, 22) détectent les points distinctifs de l'objet (13) sans contact mécanique, de préférence de manière optique.

5. Procédé d'après une des revendications précédentes, **caractérisé en ce qu'**en tant que points distinctifs ou encore sections distinctives de l'objet (13) sont détectées ses mesures extérieures, le centre étant de préférence situé en position de but (14) après le positionnement de l'objet.

6. Procédé d'après une des revendications précédentes, **caractérisé en ce que** respectivement au moins un organe sensitif (20, 22) est déplacé par un moyen de déplacement, étant de préférence une courroie (17) avec un moyen d'entraînement mené en tant que boucle.

7. Procédé d'après la revendication 6, **caractérisé en ce qu'**au moins deux organes sensitifs (20, 22) sont bougés par un moyen de déplacement commun, que de préférence auprès de chaque brin (19, 21) d'une courroie (17) conduit en tant que boucle est disposé un organe sensitif (20, 22) en direction vers l'objet (13), le plan de roulement de la boucle en particulier étant orienté essentiellement en direction vers l'objet.

8. Procédé d'après une des revendications précédentes, **caractérisé en ce que** la position au moins d'un organe sensitif (20, 22) est détectée et enregistrée en tant que signal de position utilisé pour le positionnement de l'objet (13), enregistrée notamment par un moyen de déplacement (17) pour l'organe sensitif, des changements de position relatifs de l'organe sensitif étant détectés de préférence.

9. Procédé d'après la revendication 8, **caractérisé en ce que** la différence de chemin (B) entre la position du deuxième organe sensitif (22) au moment où le premier organe sensitif (20) atteint son point caractéristique et la position dans laquelle le deuxième organe sensitif atteint son point caractéristique est enregistrée, que l'objet (13) est détecté par des moyens de positionnement (11) et déplacé d'une mesure correspondant à la moitié de la différence de chemin (B/2) en direction de mouvement du premier organe sensitif, à la suite de quoi il est en position de but (14) et il est relâché par les moyens de positionnement.

10. Procédé d'après une des revendications précédentes, **caractérisé en ce qu'**au moins un organe sensitif (20, 22) est déplacé au moins en partie de manière synchrone avec les moyens de positionnement (11) pour l'objet (13), un moyen de déplacement (17) pour l'organe sensitif faisant de préférence partie des moyens de positionnement, formant en particulier les moyens de positionnement.

11. Procédé d'après une des revendications précédentes, **caractérisé en ce que** deux organes sensitifs (20, 22) sont déplacés à partir d'une position initiale, dans laquelle ils présentent une correspondance prédéterminée par rapport à des points caractéristiques de l'objet (13) et/ou de la position de but (14), le long d'un chemin en marchant de manière synchrone en sens inverse l'un par rapport à l'autre relativement à l'objet, jusqu'à ce qu'un premier organe sensitif (20) ait atteint son point caractéristique auprès de l'objet, qu'ensuite l'objet soit détecté par les moyens de positionnement (11) et qu'il soit déplacé avec son deuxième point caractéristique en direction du deuxième organe sensitif (22), les organes sensitifs étant déplacés simultanément avec les moyens de positionnement, notamment le deuxième organe sensitif en sens contraire par rapport à l'objet, et que l'objet, après que le deuxième organe sensitif ait atteint le deuxième point caractéristique, soit en position de but et qu'il soit relâché.

12. Dispositif pour le positionnement d'un objet (13) dans une position que l'on se propose d'atteindre ou de but (14), l'objet étant notamment un substrat d'électronique industrielle, dispositif qui présente au moins deux organes sensitifs (20, 22), qui sont réalisés pour la détection d'un objet et qui sont mobiles essentiellement le long du moyen de positionnement (P) de l'objet, avec une commande, qui est raccordée avec au moins un organe sensitif, et avec des moyens de positionnement (11) pour le positionnement de l'objet dans la position de but en dépendance de la commande, **caractérisé en ce que** les organes sensitifs (20, 22) sont appliqués sur au moins un moyen de déplacement (17), qui déplace les organes sensitifs dans des sens de marche contraires.

13. Dispositif d'après la revendication 12, **caractérisé en ce que** les organes sensitifs (20, 22) sont appliqués sur au moins un moyen de déplacement (17) commun, qui déplace les organes sensitifs de manière synchrone dans des sens de marche contraires.

14. Dispositif d'après la revendication 13, **caractérisé en ce que** le moyen de déplacement est une courroie (17) menée en tant que boucle avec un moyen d'entraînement, laquelle présente notamment sur chaque brin (19, 21) un organe sensitif (20, 22) étant dirigé vers l'objet (13), le plan de roulement de la boucle de préférence étant dirigé essentiellement vers l'objet.

15. Dispositif d'après une des revendications de 12 à 14, **caractérisé en ce que** les organes sensitifs (20, 22) présentent dans une position initiale une correspondance prédéterminée par rapport à la position de but (14), ceux-ci étant disposés de préférence symétriquement par rapport à la position de but.

16. Dispositif d'après une des revendications de 12 à 15, **caractérisé par** au moins un moyen de détection de la position pour la position d'au moins un organe sensitif (20, 22), qui est raccordée avec la commande pour les moyens de positionnement (11) et pour les organes sensitifs, le moyen de détection de la position étant raccordé de préférence avec un moyen d'entraînement et/ou avec le moyen de déplacement (17) pour les organes sensitifs.

17. Dispositif d'après la revendication 13 ou 14, **caractérisé en ce qu'**au moins un moyen de déplacement (17) pour les organes sensitifs (20, 22) fait partie des moyens de positionnement (11) pour l'objet (13), notamment peut être mis en rapport d'action avec l'objet, le moyen de déplacement de préférence formant essentiellement les moyens de positionnement.

18. Dispositif d'après une des revendications de 12 à 17, **caractérisé en ce que** le moyen de déplacement (17) et/ou les moyens de positionnement (11) sont disposés au-dessous de l'objet (13) qui se trouve sur un support (12), et qu'ils peuvent être ramenés vers le haut par des discontinuités dans le support et qu'ils fonctionnent en direction de positionnement (P), le support étant de préférence un transporteur à rouleaux ou similaires pour le transport de l'objet, lequel transporteur s'étend notamment dans une direction transversale par rapport à la direction de positionnement.
